Europäisches Patentamt

European Patent Office

Office européen des brevets

(19)

(11) **EP 1 308 997 A2**

(12) **EUROPÄISCHE PATENTANMELDUNG**

(43) Veröffentlichungstag:
   **07.05.2003 Patentblatt 2003/19**

(51) Int Cl.⁷: **H01L 21/66**

(21) Anmeldenummer: **02102534.1**

(22) Anmeldetag: **05.11.2002**

(84) Benannte Vertragsstaaten:
   **AT BE BG CH CY CZ DE DK EE ES FI FR GB GR IE IT LI LU MC NL PT SE SK TR**
   Benannte Erstreckungsstaaten:
   **AL LT LV MK RO SI**

(30) Priorität: **06.11.2001 DE 10154392**

(71) Anmelder:
   • **Philips Corporate Intellectual Property GmbH**
     **20099 Hamburg (DE)**
   Benannte Vertragsstaaten:
   **DE**

   • **Koninklijke Philips Electronics N.V.**
     **5621 BA Eindhoven (NL)**

(72) Erfinder: **Schröder, Hans-Ulrich**
     **52088, Aachen (DE)**

(74) Vertreter: **Volmer, Georg, Dipl.-Ing. et al**
     **Philips Corporate Intellectual Property GmbH,**
     **Postfach 50 04 42**
     **52088 Aachen (DE)**

(54) **Ladungsdetektor-Halbleiterbauelement, System aus einem Ladungsdetektor-Halbleiterbauelement und einem Referenz-Halbleiterbauelement, Wafer, Verwendung eines Wafers und Verfahren zur qualitativen Messung einer Aufladung eines Wafers**

(57)   Die Erfindung bezieht sich auf ein Ladungsdetektor-Halbleiterbauelement in Form einer auf einem Halbleitermaterial aufgebrachten Struktur, welche eine nicht-flüchtige Speicherzelle aufweist, in Form eines MOS-Feldeffekt-Transistors mit einem Transistor-Gate, und einer MOS-Kapazität mit einem Kapazitäts-Gate. Die Erfindung bezieht sich weiter auf ein System aus einem Ladungsdetektor-Halbleiterbauelement und einem Referenz-Halbleiterbauelement. Weiter bezieht sich die Erfindung auf einen Wafer sowie die Verwendung eines Wafers mit einer Anzahl von Ladungsdetektor-Halbleiterbauelementen und/oder Systemen. Schließlich bezieht sich die Erfindung auf ein Verfahren zur qualitativen und quantitativen Messung einer plasmainduzierten Aufladung eines Wafers während der Prozessierung des Wafers. Gemäß der Erfindung kann die Ladung, welche während der Prozessierung von Wafern und Herstellung von Halbleiterbauelementen, insbesondere durch Plasma- und Ionenimplantationsprozesse entsteht, genau gemessen werden. Der Prozessablauf kann kontinuierlich überwacht werden und die Struktur ist in einer Standard-CMOS-Technologie herstellbar.

Fig. 1

EP 1 308 997 A2

**Beschreibung**

Die Erfindung bezieht sich auf ein Ladungsdetektor-Halbleiterbauelement in Form einer auf einem Halbleitermaterial aufgebrachten Struktur, das eine nicht-flüchtige Speicherzelle aufweist, in Form eines MOS-Feldeffekt-Transistors mit einem Transistor-Gate und einer MOS-Kapazität mit einem Kapazitäts-Gate. Die Erfindung bezieht sich weiter auf ein System aus einem Ladungsdetektor-Halbleiterbauelement und einem Referenz-Halbleiterbauelement. Weiter bezieht sich die Erfindung auf einen Wafer sowie die Verwendung eines Wafers mit einer Anzahl von Ladungsdetektor-Halbleiterbauelementen und/oder Systemen. Schließlich bezieht sich die Erfindung auf ein Verfahren zur qualitativen und quantitativen Messung einer Aufladung eines Wafers bei der Prozessierung des Wafers.

Das Aufladen von Wafern, Wafer "Charging", ist ein Phänomen, das während der Herstellung von Halbleiterbauelementen kontinuierlich auftritt, da viele Prozessschritte im Plasma stattfinden oder mit geladenen Teilchen durchgeführt werden. Insbesondere die dünnen Gateoxide von MOS Transistoren in CMOS-artigen Technologien, also CMOS- und BICMOS- oder ähnliche Technologien, können durch die während eines Prozessschrittes auf leitenden Oberflächen, aus z.B. Polysilizium oder Metall, gesammelte Ladung und dem resultierenden Tunnelstrom zerstört werden. Oft ist dieses Charging eine Ursache für eine niedrige Produktionsausbeute.

In der Produktentwicklung wird versucht, den Einfluss auf die Ausbeute durch das Charging mittels sogenannter Antennenregeln zu reduzieren.

In der Prozessführung wird mittels Testwafer, sogenannte CHARM-Wafer (Charging Monitore) versucht, die Prozessschritte und das Equipment herauszufinden, welche besonders viel Charging und somit niedrigere Ausbeute verursachen.

Die Prozesskontrolle mittels eines CHARM-Wafers ist jedoch aufwendig und teuer, insbesondere da zur Messung eines oder mehrerer CHARM-Wafer eine Produktion angehalten werden muss.

Aus der JP-10-284726 ist eine aus einem p-Kanal- und einem n-Kanal-MOS-Transistor bestehende Struktur und ein Verfahren zum Messen von Wafer-Charging in Plasma-haltiger Umgebung beschrieben. Die Struktur erfordert ein Messen vor und nach dem Plasmaprozessschritt. Dies ist nur möglich, wenn die Struktur kontaktiert wird. Somit kann die Kontrolle von Produktionsware mit der Struktur allenfalls für Plasmaschritte am Ende des Herstellungsprozesses eingesetzt werden.

In der US 5,959,309 ist eine Struktur bestehend aus einer Antenne, einem Diodenstrang, einem sperrenden und einem durchlassenden Transistor und einer Speicherkapazität zum Messen von Wafer-Charging in Plasma-haltiger Umgebung beschrieben. Dort ist auch ein Verfahren, bei dem die fertige Struktur in einem "Ist"-Zustand in einer Plasmaanlage platziert wird, beschrieben. Nach Beendigung des Plasmaprozesses wird der "End"-Zustand ausgelesen und mit dem Ausgangs-"Ist"-Zustand verglichen. Aus der Differenzmessung lässt sich ein Maß für das Charging des vorher durchgeführten Schrittes ermitteln. Mit dieser Methode kann eine Anlage kontrolliert werden. Die Kontrolle kann jedoch nicht während der Produktion von Nutzmaterial durchgeführt werden.

Die Verfahren beider vorgenannter Veröffentlichungen haben eine Reihe von Nachteilen. So sind die teuren Produktionsanlagen während der Kontrolle auf Wafer-Charging nicht in Produktion. Der Produktionsausfall verursacht erhebliche Kosten.

Des weiteren werden teure Testwafer, wie z.B. als CHARM-Wafer bekannt, für die Kontrolle benötigt.

Schließlich wind die Anlage nur zu einem bestimmten Zeitpunkt kontrolliert. Die laufende Produktion bleibt dabei jedoch unkontrolliert.

Die in der JP-10-284726 und der US 5,959,309 beschriebenen Strukturen ermöglichen außerdem keine sehr genaue Beurteilung des Chargings. Insbesondere ist keine Analyse für einen beliebigen Prozessschritt möglich.

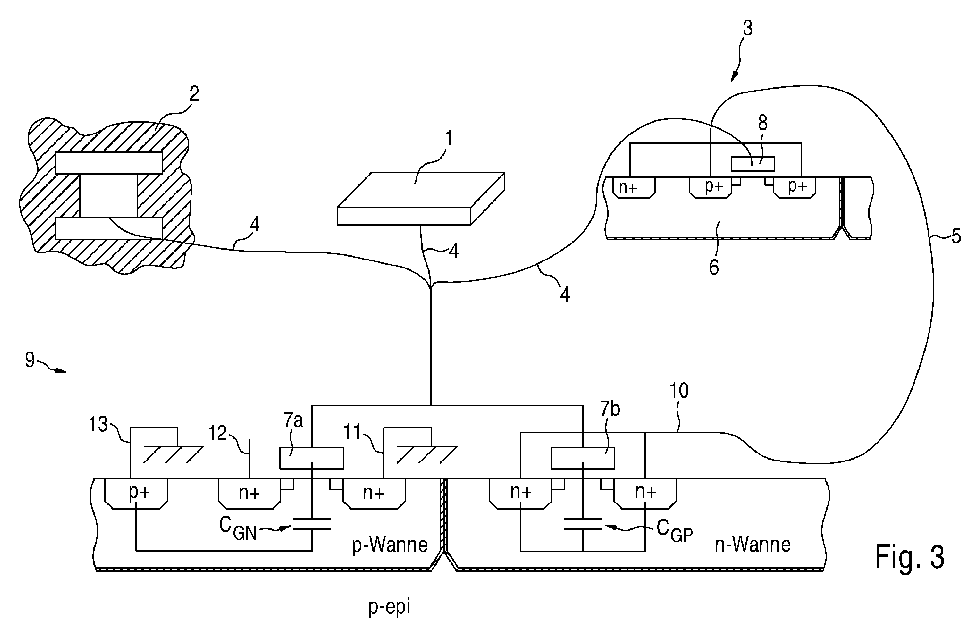

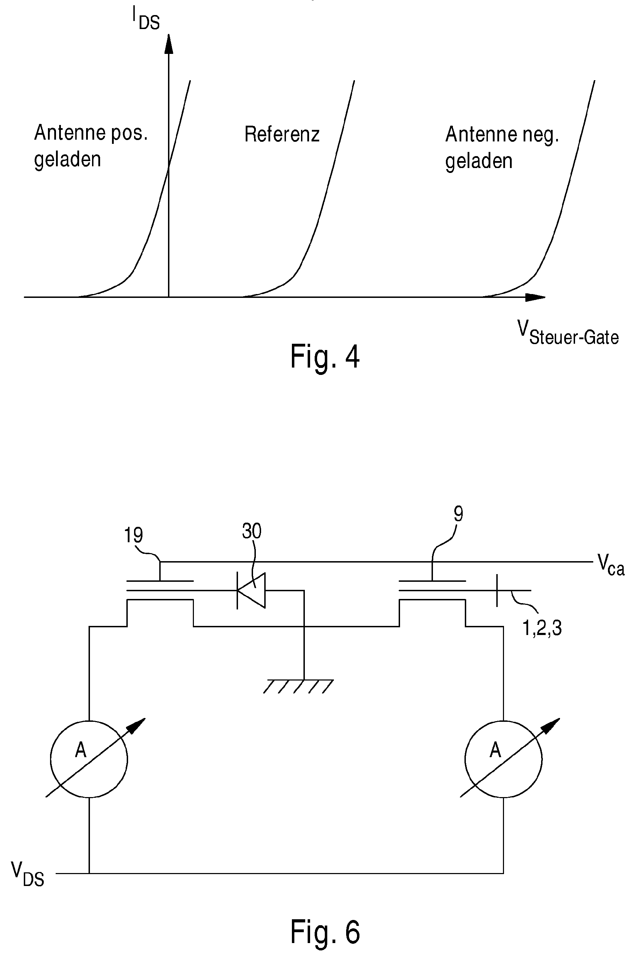

Darüber hinaus sind die Strukturen nicht kompatibel zu den CMOS-Herstellungsverfahren, da sie keinen CMOS-Technologie-artigen Aufbau und keine CMOS-Technologie-artige Verschaltung aufweisen, so dass eine Reihe von über CMOS-Technologie-Standards hinausgehende Prozessschritte notwendig sind. So ist festzustellen, dass die Struktur der JP 10-284726 nicht kompatibel zu den Standard-CMOS-Herstellungsverfahren ist, da sie zwei Polysiliziumebenen (4 und 3 in der Figur 3) verwendet. Die Struktur im Patent US 5,959,309 ist nicht kompatibel zu dem Standard-CMOS-Herstellungsverfahren, da sie einerseits eine hochqualitative Kapazität (46 in den Figuren 4a und 4b) verwendet, welche man in einem CMOS-Prozess in der Regel mit zwei übereinanderliegenden Polysiliziumebenen herstellen würde. Infolgedessen wird im Vergleich zu dem Standard-CMOS-Prozess ebenfalls eine zusätzliche Polysiliziumebebene benötigt. Darüber hinaus erfordert der Photodiodenstring (43 in der Figur 4a), dass die über der Photodiode liegenden Schichten transparent sind. Dies muss in einem Standard-CMOS-Prozess aber nicht der Fall sein. Weiter kann ein Siliziumhalbleiter eventuell nicht Plasmastrahlung des komplett auftretenden Spektrumbereichs absorbieren. Eine Anwendung der dort beschriebenen Strukturen auf Produktionsware im Rahmen einer CMOS-Prozessierung eines Wafers ist somit ausgeschlossen.

Aus der Veröffentlichung "EEPROM-Struktur in CMOS-Technologie mit einer Polysiliziumebene", Shaker Verlag, ISBN 3-8265-3289-9, Aachen 1998, und der WO 00/60672 ist eine nichtflüchtige Speicherzelle bekannt, die in einem Standard-CMOS Prozess hergestellt werden kann. Sie eignet sich jedoch nicht als Monitor für Wafer Charging, also als ein Wafer Charging Detector Device.

Aufgabe der vorliegenden Erfindung ist es, eine Struktur anzugeben, die auf einer nichtflüchtigen Speicherstruktur basiert und als eine Process-Control-Monitor-(PCM)-Struktur wirkt. Weiter ist es Aufgabe eine Verwendung der Struktur und ein Verfahren anzugeben, mit der die Ladung gemessen werden kann, welche während eines Prozessschrittes auf einem Wafer an einem bestimmten Ort entstanden ist, wobei die Struktur während der Produktion und/oder Prozessierung des Wafers in einer CMOS- oder BICMOS-Technologie hergestellt ist.

Die Erfindung geht zur Lösung der Aufgabe bezüglich der Struktur gemäß einer ersten Variante aus von einem Ladungsdetektor-Halbleiterbauelement in Form einer auf einem Halbleitermaterial aufgebrachten Struktur, das eine nicht flüchtige Speicherzelle aufweist, in Form

eines MOS-Feldeffekt-Transistors mit einem Transistor-Gate, vorteilhaft auch -Source und -Drain, und

einer MOS-Kapazität mit einem Kapazitäts-Gate, vorteilhaft auch -Source und -Drain. Bei einem solchen Ladungsdetektor-Halbleiterbauelement ist erfindungsgemäß vorgesehen:

Eine Antenne, die mit dem Kapazitäts-Gate mittels einer Wirkverbindung verbunden ist, wobei

das Kapazitäts-Gate mit dem Transistor-Gate mittels einer weiteren Wirkverbindung derart verbunden ist, dass eine Aufladung der Antenne über die Speicherzelle speicherbar und bei Bedarf abrufbar ist, und wobei die Struktur einen CMOS-Technologie-artigen Aufbau aufweist.

Die Erfindung sieht zur Lösung der Aufgabe bezüglich der Struktur gemäß einer zweiten Variante erfindungsgemäß vor Ein System aus einem Ladungsdetektor-Halbleiterbauelement und einem Referenz-Halbleiterbauelement, in Form einer auf einem Halbleiter-Material aufgebrachten Struktur, wobei das Ladungsdetektor-Halbleiterbauelement eine nicht-flüchtige Detektor-Speicherzelle aufweist, in Form

eines ersten MOS-Feldeffekt-Transistors mit einem Detektor-Transistor-Gate, vorteilhaft auch -Source und -Drain, und einer ersten MOS-Kapazität mit einem Detektor-Kapazitäts-Gate, vorteilhaft auch -Source und -Drain,

und das eine Antenne umfasst, die mit dem Detektor-Kapazitäts-Gate mittels einer ersten Wirkverbindung verbunden ist, wobei

das Detektor-Kapazitäts-Gate mittels einer ersten Wirkverbindung verbunden ist, wobei das Detektor-Kapazitäts-Gate mit dem Detektor-Transistor-Gate mittels einer weiteren ersten Wirkverbindung verbunden ist, und wobei

das Referenz-Halbleiterbauelement eine nicht-flüchtige Referenz-Speicherzelle aufweist, in Form eines zweiten MOS-Feldeffekt-Transistors mit einem Referenz-Transistor-Gate, vorteilhaft auch -Source und -Drain, und einer zweiten MOS-Kapazität mit einem Referenz-Kapazitäts-Gate, vorteilhaft auch -Source und Drain,

und eine Masseleitung umfasst, die mit dem Referenz-Kapazitäts-Gate mittels einer zweiten Wirkverbindung verbunden ist, wobei das Referenz-Kapazitäts-Gate mit dem Referenz-Transistor-Gate mittels einer weiteren zweiten Wirkverbindung verbunden ist.

Die Erfindung geht dabei von der Erkenntnis aus, dass es möglich ist, die Struktur in der ersten und zweiten Variante während der Produktion des Wafers in jedem verwendeten CMOS/BICMOS-Standard-Verfahren herzustellen. Die Struktur weist also einen CMOS-Technologie-artigen Aufbau auf. Das heißt, in der Struktur wind nur von Einheiten Gebrauch gemacht, die auch in jedem verwendeten CMOS/BICMOS-Standard-Verfahren herzustellen sind. Insbesondere wird von Einheiten wie NMOS- und PMOS-Transistoren Gebrauch gemacht. Solche Einheiten stehen in jedem CMOS-Prozess zur Verfügung. Die obige Struktur kann somit auf jedem Produktionswafer vorhanden sein, ohne dass zusätzliche Prozessschritte nötig wären.

Insbesondere sind Einheiten, welche mehrere Polysilizium-Ebenen voraussetzen, vermieden. Ein kontinuierliches Monitoren des Charging-Effektes für die laufende Produktion ist nach der Erkenntnis nur mit der wie beschrieben geeigneten PCM-Struktur (Process-Control-Monitor-Struktur) möglich. Die obige PCM-Struktur ist in der Lage, Ladung, welche während der Prozessführung entsteht, nichtflüchtig zu speichern. Infolgedessen verwendet die obige PCM-Struktur eine nichtflüchtige Speicherzelle. Für die Herstellung nichtflüchtiger Speicherzellen sind in der Regel zusätzliche Prozessschritte notwendig, so dass der Einsatz in einer Standard-CMOS oder BICMOS Technologie oder ähnlichen Technologien bisher nicht möglich ist. Zusätzliche Prozessschritte oder eine Änderung der Prozessfolge zur Herstellung der Struktur bei einem Standard-CMOS-Prozess ist bei der obigen PCM-Struktur nach der Erkenntnis der Erfindung jedoch nicht notwendig.

Nur so ist eine Kontrolle der Produktionsware, insbesondere bei der Prozessierung des Wafers, gewährleistet. Die Struktur ist somit einerseits kostenneutral herzustellen und bietet andererseits die einzige Möglichkeit, Produktionsware bei der Prozessierung des Wafers zu überwachen, ohne den Produktionsablauf zu verzögern. Insbesondere kann die Produktionsware kostengünstig laufend überwacht und eine kontinuierliche Beurteilung des Chargings getroffen werden. Insbesondere werden teure Testwafer vermieden.

Weitere vorteilhafte Weiterbildungen der Erfindung bezüglich der Struktur in der ersten und zweiten Variante sind den Unteransprüchen zu entnehmen.

Vorzugsweise weist ein Ladungsdetektor-Halbleiterbauelement und/oder ein Referenz-Halbleiterbauelement einen ersten Bereich mit dem MOS-Feldeffekt-Transistor und einer ersten Wanne und einen zweiten Bereich mit der MOS-Kapazität und einer zweiten Wanne, auf, wobei die erste Wanne und die zweite Wanne mit unterschiedlichen Vorzeichen dotiert sind. Günstigerweise ist die erste Wanne eine p-Wanne und die zweite Wanne eine n-Wanne. Insbesondere ist der MOS-Feldeffekt-Transistor ein NMOS-Feldeffekt-Transistor, und die MOS-Kapazität eine geschichtete Polysilizium/n-Wannen-Kapazität.

Gemäß einer Weiterbildung der Erfindung sind die Antenne, das Kapazitäts-Gate und das Transistor-Gate leitend verbunden, insbesondere galvanisch verbunden.

Vorteilhaft ist ein Steuer-Gate durch eine Wanne oder die Source/Drain-Anschlüsse der Kapazität gebildet. Dies hat zusätzlich den Vorteil, dass die Speicherzelle auf besonders günstige Weise ausgelesen werden kann.

Des weiteren ist vorteilhaft das Transistor-Gate und das Kapazitäts-Gate als eine Polysiliziumplatte ausgeführt.

Insbesondere ist die Struktur der ersten und der zweiten Variante derart aufgebaut, dass das Halbleiter-Material in einer ersten Ebene angeordnet ist, auf der die nicht-flüchtige Speicherzelle in einer zweiten Ebene aufgsbracht ist, auf welcher wiederum die Verbindungen, das Transistor-Gate, das Kapazitäts-Gate sowie die Antenne oder die Masseleitung in einer dritten Ebene aufgebracht ist. Dabei erweist es sich als besonders günstig, dass das Transistor-Gate und das Kapazitäts-Gate gemeinsam in einer Polysilizium-Ebene verbunden sind.

Ein Aufbau gemäß einer dieser Weiterbildungen hat den Vorteil, dass ein Herstellungsverfahren für die Struktur kompatibel zu den CMOS-artigen Herstellungsverfahren, insbesondere den Standard-CMOS-Verfahren ist.

Damit die Antenne das Kapazitäts-Gate des Detektors dominiert, übersteigt vorteilhaft die Fläche der Antenne die Fläche der Polysiliziumplatte.

Die Antenne kann gemäß einer Reihe von Weiterbildungen der Erfindung vorteilhaft kompatibel zu einer Standard-CMOS-Technologie ausgeführt werden. Die Antenne kann als eine Polysilizium-Schicht ausgeführt sein. Hinsichtlich der CMOS-kompatiblen Ausführung ist die Antenne vorteilhaft mit einer einzigen Polysilizium-Schicht ausgeführt. Alternativ kann die Antenne auch aus Metall ausgeführt sein. Insbesondere kann die Antenne auch als eine Kontakt-Antenne, insbesondere Via-Antenne, ausgeführt sein. Gemäß einer anderen Weiterbildung ist die Antenne vorteilhaft als eine MOS-Kapazität, insbesondere als eine NMOS-Kapazität, ausgeführt. Somit ist gewährleistet, dass alle Ebenen, in denen Charging auftreten kann, kontrolliert werden.

Die Erfindung führt weiter auf einen Wafer, bei dem auch die vorgenannten Merkmale der Weiterbildungen der Erfindung verwirklicht sein können. Die Erfindung sieht zur Lösung der Aufgabe bezüglich des Wafers, einen Wafer vor, beispielsweise einen Silizium-Wafer, der erfindungsgemäß mit einer Anzahl von Ladungsdetektor-Halbleiterbauelementen der oben genannten Art und/oder Systemen der oben genannten Art ausgestaltet ist. Vorteilhaft handelt es sich dabei um einen Produktionswafer, also keinen Testwafer, auf dem die oben genannte Struktur zusammen mit der Produktionsware prozessiert wird. Die oben genannte Struktur kann allerdings auch bereits auf dem Produktionswafer hergestellt sein. In beiden Fällen erfolgt die Herstellung bzw. Prozessierung in einer CMOS-artigen Technologie. Dies hat den Vorteil, dass die Struktur auf jedem Produktionswafer vorhanden ist. Vorzugsweise ist die oben genannte Struktur in einer Sägebahn des Wafers untergebracht, was vorteilhaft den zur Verfügung stehenden Platz auf dem Wafer effektiv nutzt. Die Prozessierung der Produktionsware erfolgt nämlich auf dem übrigen Bereich des Wafers. Gemäß einer Weiterbildung der Erfindung ist die oben genannte Struktur gemäß einer vorbestimmten örtlichen Verteilung auf dem Wafer hergestellt und/oder prozessiert. Dies ermöglicht eine ortsaufgelöste und/oder prozessselektive Messung einer Aufladung.

Zur Lösung der Aufgabe bezüglich der Verwendung ist erfindungsgemäß eine Verwendung eines Wafers der oben genannten Art mit einer Anzahl von Ladungsdetektor-Halbleiterbauelementen der obengenannten Art und/oder Systemen der oben genannten Art zur qualitativen und quantitativen Messung einer Aufladung, insbesondere plasmainduzierten Aufladung des Wafers bei der Prozessierung des Wafers, vorgesehen. Gemäß einer Weiterbildung der Erfindung ist eine vorbestimmte örtliche Verteilung der Anzahl zur ortsaufgelösten und/oder prozessschrittselektiven Messung einer Aufladung, insbesondere plasmainduzierten Aufladung, des Wafers bei der Prozessierung des Wafers vorgesehen.

Bezüglich des Verfahrens wind die Aufgabe erfindungsgemäß gelöst durch ein Verfahren zur qualitativen und quantitativen Messung einer Aufladung insbesondere plasmainduzierten Aufladung, eines Wafers bei der Prozessierung des Wafers. Dabei wird

- der Wafer unter Verwendung einer CMOS-artigen Technologie hergestellt,
- der Wafer bei der Herstellung mit einem System aus einem Ladungsdetektor-Halbleiterbauelement und einem Referenz-Halbleiterbauelement versehen,

wobei das Ladungsdetektor-Halbleiterbauelement eine nicht-flüchtige Detektor-Speicherzelle aufweist, in Form eines ersten MOS-Feldeffekt-Transistors mit einem Detektor-Transistor-Gate, vorteilhaft - Source und -Drain, und einer ersten MOS-Kapazität mit einem Detektor-Kapazitäts-Gate, vorteilhaft -Source und -Drain,
und eine Antenne umfasst,
die mit dem Detektor-Kapazitäts-Gate mittels einer ersten Wirkverbindung verbunden ist, wobei

das Detektor-Kapazitäts-Gate mit dem Detektor-Transistor-Gate mittels einer weiteren ersten Wirkverbindung verbunden ist, und
wobei das Referenz-Halbleiterbauelement
eine nicht-flüchtige Referenz-Speicherzelle aufweist, in Form
eines zweiten MOS-Feldeffekt-Transistors mit einem Referenz-Transistor-Gate, vorteilhaft - Source und -Drain, und
einer zweiten MOS-Kapazität mit einem Referenz-Kapazitäts-Gate, vorteilhaft -Source und -Drain,
und eine Masseleitung umfasst,
die mit dem Referenz-Kapazitäts-Gate mittels einer zweiten Wirkverbindung verbunden ist,
wobei das Referenz-Kapazitäts-Gate mit dem Referenz-Transistor-Gate mittels einer weiteren zweiten Wirkverbindung verbunden ist und wobei die Struktur einen CMOS-Technologie-artigen Aufbau aufweist,

- bei der Prozessierung das Detektor-Kapazitäts-Gate über die Antenne und das Referenz-Kapazitäts-Gate gegebenenfalls aufgeladen und das Referenz-Kapazitäts-Gate über die Masseleitung entladen,
- und die Aufladung des Detektor-Kapazitäts-Gates mit der Aufladung des Referenz-Kapazitäts-Gates mittels einer Messung verglichen.

Vorteilhaft ist der Wafer mit einer Anzahl von vorbestimmt örtlich verteilten Systemen hergestellt.
Weitere vorteilhafte Weiterbildungen der Erfindung bezüglich des Verfahrens sind den Unteransprüchen zu entnehmen.
Gemäß einer Weiterbildung der Erfindung wird zur Messung die Schwellspannung des Ladungsdetektor-Halbleiterbauelementes mit der Schwellspannung des Referenz-Halbleiterbauelementes verglichen.
Alternativ können auch die Drain-Ströme bei gleich angelegten, Steuergate-Potentialen jeweils des Ladungsdetektor-Bauelementes und des Referenz-Halbleiterbauelementes verglichen werden. Das Steuergate-Potential ist dabei insbesondere durch eine Wanne oder die Source/Drain-Anschlüsse jeweils der Kapazität des Detektor-Halbleiterbauelementes und des Referenz-Halbleiterbauelementes gebildet.
Ausführungsbeispiele der Erfindung werden nachfolgend anhand der Zeichnung beschrieben. Diese soll die Ausführungsbeispiele nicht maßstäblich darstellen; vielmehr ist die Zeichnung, wo zur Erläuterung dienlich, in schematisierter und/oder leicht verzerrter Form ausgeführt. Im Hinblick auf Ergänzungsn der aus der Zeichnung unmittelbar erkennbaren Lehren wird auf den einschlägigen Stand der Technik verwiesen. Im übrigen wurden gleiche Bezugszeichen für gleiche Elemente verwendet. Im einzelnen zeigen:

Figur 1: einen Querschnitt einer bevorzugten Ausführungsform des Ladungsdetektor-Halbleiterbauelementes, nämlich ein Wafer Charging Detector Device;

Figur 2: mögliche Antennen a), b) und c) des Wafer Charging Detector Devices gemäß Figur 1;

Figur 3: einen Querschnitt des Wafer Charging Detector Device der Figur 1 mit möglichen Anschlüssen für die Antennen gemäß Figur 2;

Figur 4: Ladungszustände des Wafer Charging Detector Device anhand einer Steuerkennlinie;

Figur 5: einen Querschnitt einer bevorzugten Ausführungsform eines Referenz-Halbleiterbauelementes, nämlich einer Referenzstruktur des Wafer Charging Detector Device zur Verwendung bei einer bevorzugten Ausführungsform, des Systems;

Figur 6: Auswerteverfahren des Wafer Charging Detector Device mittels Referenzmessung zu einer Referenzstruktur gemäß Figur 5.

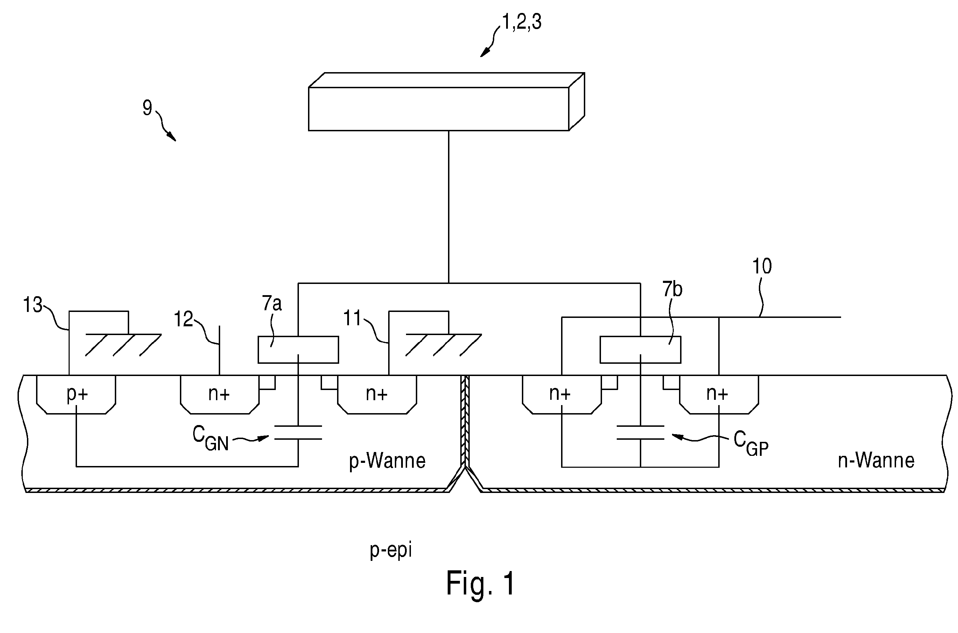

Beim Wafer Charging Detector Device 9 der Figur 1 besteht die nichtflüchtige Speicherzelle aus einem NMOS Transistor und einer geschichteten Polysilizium/n-Wanne-Kapazität. Die n+-Diffusionsgebeite der Poly/n-Wanne-Kapazität können beliebig durch p+-Diffusionsgebiete ersetzt werden. Das Gate des NMOS-Transistors 7a und eine Polysiliziumplatte der geschichteten Poly/n-Wanne-Kapazität 7b sind gemeinsam in einer Polysilizium-Ebene galvanisch verbunden. Darüber hinaus ist die Antenne 1, 2 oder 3 galvanisch an die Polysiliziumplatte angeschlossen, welche Teil des Kapazitäts-Gates 7b ist. Diese Einheit hat die Funktion eines Floating-Gates 7. Damit das Floating-Gate 7 (Kapazitäts-Gate) von der Antenne 1, 2, 3 dominiert wird, ist die Fläche der Antenne 1, 2, 3 zumindest größer als die Polysiliziumplatte. Das Steuer-Gate 10 wird durch die n-Wanne der Kapazität bzw. die n+-Anschlüssen der geschichteten Polysilizium/n-Wanne-Kapazität gebildet. Der Drain-Anschluss 12 des NMOS-Transistors stellt den Leseanschluss des Wafer Charging Detector Device dar. 11 bezeichnet den Source-, 12 den Drain - und 13 den p-sub-Anschluss der p-Wanne des NMOS-Transistors. Der Source-Anschluss 12 bildet den Schreibanschluss 12 (Bit-Line).

Die Antenne 1, 2, 3 ist mit dem Kapazitäts-Gate 7 galvanisch verbunden. Die Gatt-Kapazität $C_{GP}$ und $C_{GN}$ sind durch Symbole ebenfalls schematisch angegeben.

Eine graphische Übersicht möglicher Antennen und ihrer Realisierung lässt sich wie folgt angeben:

<u>Antenne:</u>        PS oder PSS,

NMOST $\left.\begin{array}{l} \\ \\ \\ \end{array}\right\}$ bedeckte Platte.

PMOST     SN, SP oder

Bipolar Implant     bipolare Implant-Maske

PSS

$\left.\begin{array}{l} CO \\ COS \end{array}\right\}$ CO oder COS bedeckt durch PS, IN, oder INS

$\left.\begin{array}{l} IN \\ INS \end{array}\right\}$ ein fache Platte

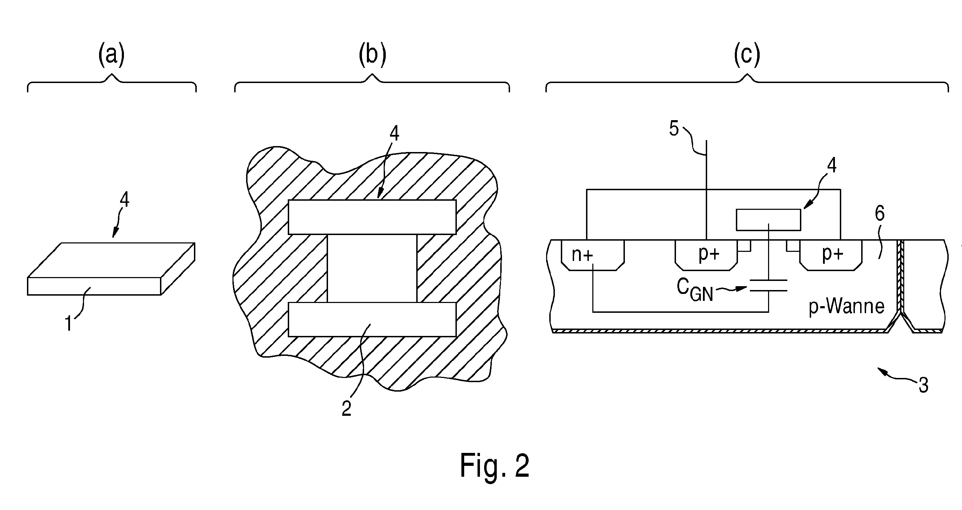

Die möglichen Antennen sind im einzelnen in der Figur 2 dargestellt. Als Antenne ist (a) eine Polysilizium- oder Metallplatte, (b) ein Kontakt oder ein Via und (c) eine MOS Kapazität möglich.

Betreffend Figur 2(a) kann eine Antenne als Polysilizium- oder Metallplatte ausgeführt sein. Sie kann z.B. als eine Interconnect-Antenne mit einer ersten Metallisierungsebene (IN) und einer zweiten Metallisierungsebene (INS), also als IN- oder INS-Antenne, ausgeführt sein.

Betreffend Figur 2(b) kann die Antenne 2 als ein Kontakt oder ein Via oder mehrere Kontakte oder Vias, also z.B. als eine Kontakt-(CO)- oder eine weitere Kontakt-(COS)-Struktur mit einer Deckschicht aus einer Polysilizium-(PS)-, einer eisten Metallisierungs-(IN)-oder einer zweiten Metallisierungs-(INS)-Struktur ausgeführt sein.

Betreffend Figur 2(c) kann eine Antenne 3 als eine MOS-Struktur, z.B. als eine MOS-Kapazität, ein NMOS-Transistor, PMOS-Transistor, als bipolare Implant-Antenne oder als eine weitere Polysilizium-(PSS)-Struktur ausgebildet sein. Insbesondere ist dazu eine PSoder PSS-Platte, d. h mit einer ersten Polysilizium-(PS)- oder einer zweiten Polysilizium-(PSS)-Ebene mit einer Deckschicht einer Shallow-n+-(SN)- oder Shallow-p+-(SP)-Struktur oder einer bipolaren Implant-Maske, möglich.

Die MOS-Kapazität ist eine Antenne für Implants. Eine Implanter-Antenne ist jedoch auch durch die Polysilizium-Platte gegeben, wenn diese implantiert wird.

$C_{GN}$ ist die NMOST-Gate-Kapazität. In allen drei Fällen ist 4 mit dem Floating-Gate verbunden. In der Figur 2(c) ist 5 mit dem Control-Gate verbunden. 6 bezeichnet eine n-Wanne.

Die Figur 3 zeigt das komplette Wafer Charging Detector Device 9 mit der Kontaktierung der unterschiedlichen Antennen 1, 2 und 3 gemäß Figur 2. Betreffend Figur 2(a) und Figur 2(b) ist die Antenne 1 oder 2 über 4 mit dem Floating-Gate 7 der Polysilizium/n-Wannen-Kapazität verbunden. Betreffend Figur 2(c) ist die Antenne als ein PMOS-Transistor ausgeführt. Dabei ist das Gate der Antenne 3 über 4 mit dem Floating-Gate 7 der Polysilizium/n-Wannen-Kapazität verbunden und das Control-Gate der Antenne über 5 mit dem Steuer-Gate 10 der Polysilizium/n-Wannen-Kapazität.

Im weiteren wird die Funktion des Wafer Charging Detector Device beschrieben.

Da viele Prozessschritte zur Herstellung von Halbleiterbauelementen im Plasma stattfinden oder mit geladenen Teilchen durchgeführt werden, wird während der Produktion auf der "floatenden" Antenne 1, 2 oder 3 elektrische Ladung gesammelt. Die Menge der Ladung welche gesammelt wird, hängt davon ab, wie viel Ladung während der Prozessschritte zur Herstellung der Antenne 1, 2 oder 3 entsteht. Die Ladung kann von der isolierten Antenne 1, 2 oder 3 nicht abfließen und wird gespeichert.

Zum Auslesen der auf der Antenne 1, 2 oder 3 gespeicherten Ladung wird an das Steuer-Gate 10 eine positive Lese-Spannung gelegt. Der Substratanschluss 13 liegt auf Massepotential. Infolgedessen fällt die Lesespannung näherungsweise an den in Reihe geschalteten Gatekapazitäten $C_{GP}$ und $C_{GN}$ ab. Bei an 10 angelegter Lesespannung ist das Kapazitäts-Gate Potential $V_{FG}$ abhängig vom Verhältnis der Gatekapazitäten $C_{GP}$, $C_{GN}$, der Kapazität der Antenne 1, 2 oder 3 ($C_{Antenna}$) und der Ladung $Q^{Antenna}$ auf der Antenne 1, 2 oder 3 bzw. dem Kapazitäts-Gate.

$$V_{FG} \approx V_{FG}^{Referenz} + \frac{1}{C_{ges}^{Antenna}} Q^{Antenna} \tag{1}$$

Wenn das auf das Kapazitäts-Gate eingekoppelte Potential größer ist als die Schwellspannung des NMOS-Transistors, bildet sich unter dem Gate zwischen Source- und Draindiffusionen des NMOS-Transistors eine Inversionsschicht aus. Der NMOS-Transistor des Wafer Charging Detector Device ist also eingeschaltet. Bei angelegter Drainspannung kann ein Stromfluss am Drain detektiert werden.

Ist die Antenne 1, 2 oder 3 während der Produktion jedoch negativ aufgeladen, führt die negative Ladung zu einer Akkumulation von positiven Ladungsträgern zwischen den Source/Draindiffusionen des Wafer Charging Detector Device. Die gleiche angelegte Lese-Spannung reicht dann nicht mehr aus, um eine Inversionsschicht zu bilden. Demzufolge sperrt der NMOS-Transistor. Am Drainanschluss kann bei angelegter Drainspannung kein Stromfluss festgestellt werden.

Ist dagegen die Antenne 1, 2 oder 3 während der Produktion positiv aufgeladen, führt die positive Ladung zu einer Inversionsschicht zwischen den Source-/Draindiffusionen des Wafer Charging Detector Device. Ohne Anlagen einer Lese-Spannung ist der NMOS-Transistor eingeschaltet. Am Drainanschluss kann bei angelegter Drainspannung ein Stromfluss festgestellt werden.

Der detektierte Strom des Wafer Charging Detector Device 9 kann für alle Fälle durch folgenden Ausdruck beschrieben werden:

$$I_{DS} = \mu \frac{W}{L} C_{GN} \left[ (V_{FG} - V_T) V_{DS} - \frac{V_{DS}^2}{2} \right] \tag{2}$$

Die drei möglichen Ladungszustände "Antenne positiv geladen", "Referenz" und "Antenne negativ geladen" des Wafer Charging Detector Device sind in der Figur 4 anhand der Steuerkennlinie gemäß Formel (2) beispielhaft dargestellt.

Gemäß einer bevorzugten Ausführungsform des Verfahrens ist die Auswertung des Wafer Charging Detector Devices 9 im weiteren beschrieben.

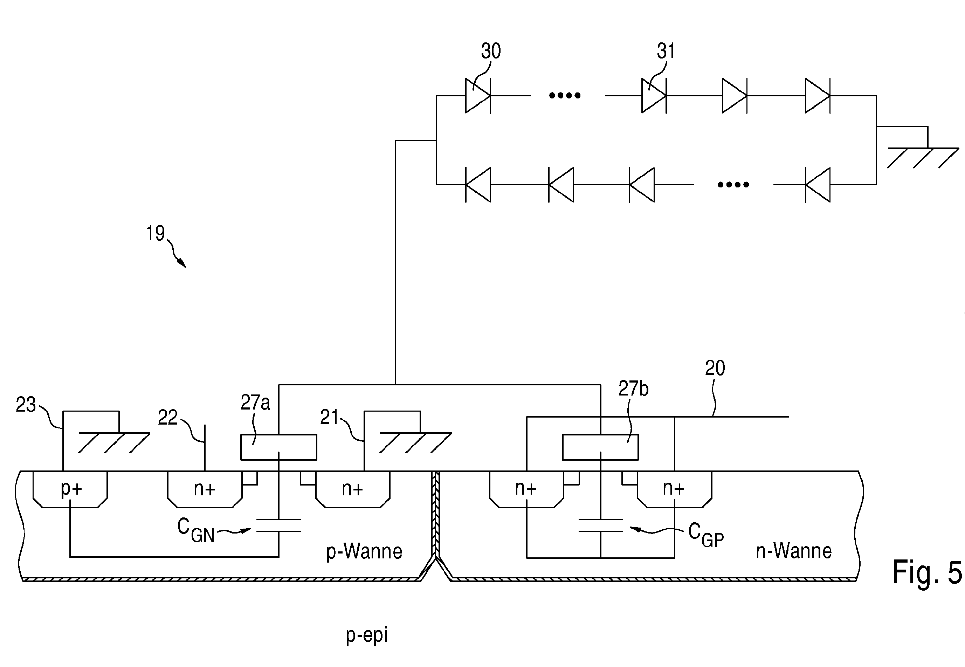

Die während eines Prozessschrittes entstandene Ladung auf dem Wafer Charging Detector Device 9 kann während der Process-Control-Monitor (PCM)-Messung durch den Vergleich mit einer Referenz-Struktur 19 gemäß Figur 5 des Wafer Charging Detector Device gemäß Figur 1 ausgewertet werden. Bei der Referenz-Struktur, welche im Prinzip genauso aufgebaut ist wie das Wafer Charging Detector Device, muss jedoch vermieden werden, dass das Kapazitäts-Gate 27 Ladung speichern kann, welche während der Prozessierung entsteht. Dies kann durch eine Diode 30 bzw. einen Diodenstack 31 durchgeführt werden. Dann kann auf dem Kapazitäts-Gate 27 keine Ladung mehr gespeichert werden, da sie als Leckstrom über Dioden 30, 31 abfließen wird.

Entsprechend bezeichnet 21 den Source-, 22 den Drain- und 23 den p-sub-Anschluss der p-Wanne der Referenzstruktur. Der Source-Anschluss 12 bildet den Schreibanschluss 12 (Bit Line). Das Steuergate 20 bildet den Leseanschluss (Word Line) bei der n-Wanne.

Durch Vergleich der Drainströme bei gleich angelegtem Steuer-Gate-Potential von Referenz-Struktur 19 und Wafer-Charging Detector Device 9 kann mittels Gleichung (1) und (2) die Ladung ermittelt werden, die während der Herstellung der betreffenden Antennen 1, 2 oder 3 entstanden ist.

Ein Beispiel einer Schaltung für die Referenzmessung des Drainstromes ist in der Figur 6 dargestellt.

Eine weitere Möglichkeit zur Ermittlung der Ladung welche durch Wafer Charging während eines bestimmten Prozessschrittes entstanden ist, ist die Messung der Schwellspannung des Wafer Charging Detector Device und der Vergleich mit der Referenzstruktur. Dazu muss die Steuerkennlinie (ähnlich wie beispielhaft in Figur 4 dargestellt) durch kontinuierliches Erhöhen des Steuer-Gate Potential $V_{Steuer-Gate}$ bei angelegter Drainspannung $V_{DS}$ durchgefahren werden. Anschließend kann die Ladung mit Gleichung (3) berechnet werden:

$$Q_{Antenne}=C_{ges}(V_{th}^{Referenz} - V_{th}^{Antenne}) \tag{3}$$

Unter der Voraussetzung, dass das Wafer Charging Detector Device 9 als PCM-Struktur mit verschiedenen Antennen 1, 2 oder 3 verwendet wird, kann der Einfluss des Wafer-Charging auf jedem Wafer jeder Charge an einem bestimmten Ort auf einem Wafer ermittelt werden. Dies erlaubt eine kontinuierliche Prozesskontrolle bezüglich des Wafer-Charging in der Produktion. Das Equipment oder der Prozessschritt, welcher zu Wafer-Charging führt, kann umgehend und kostengünstig ermittelt werden.

Im folgenden sind die in der Beschreibung und den Figuren benutzten Abkürzungen aufgeführt:

| | |
|---|---|
| MOS | Metal-Oxide-Semiconductor |
| CMOS | Complementary Metal-Oxide-Semiconductor |
| BICMOS | Bipolar und Complementary Metal-Oxide-Semiconductor |
| PCM | Process Control Monitor |
| Well | Wanne |
| Poly | Polykristallines Silizium |
| N+ | hochdotierte n-Diffusion |
| P+ | hochdotierte p-Diffusion |
| $C_{GP}$ | Gate-Kapazität des Steuer-Gates |
| $C_{GN}$ | NMOST-Gate-Kapazität |
| Via | Kontaktstruktur zwischen zwei Metallisierungsebenen |
| IN | Erste Metallisierungsebene |
| INS | Zweite Metallisierungsebene |
| CO | Kontaktstruktur zwischen Siliziummaterial bzw. Polysilizium und erster Metallisierungsebene |
| COS | Kontaktstruktur zwischen erster und zweiter Metallisierungsebene |
| PS | Polykristallines Silizium (erste Ebene) |
| PSS | Polykristallines Silizium (zweite Ebene) |
| SN | shallow n+, hochdotiertes und flaches n-Diffusionsgebiet, z. B. Source/Drain-Gebiet |
| SP | shallow p+, hochdotiertes und flaches p-Diffusionsgebiet, z. B. Source/Drain-Gebiet |
| $V_{FG}$ | Floating-Gate-Potential |
| $C_{Antenna}$ | Kapazität zwischen Antenne und Halbleitermaterial |
| $Q^{Antenna}$ | Elektrische Ladung auf der Antenne |
| $V_T$ | Schwellspannung |
| $V_{TH}$ | Schwellspannung |

$I_{DS}$        Drain/Source-Strom

μ        Beweglichkeit der Ladungsträger

W        Transistorkanal-Weite

L        Transistorkanal-Länge

$V_{DS}$        Drain/Source-Spannung


**Patentansprüche**

1. Ladungsdetektor-Halbleiterbauelement (9) in Form einer auf einem Halbleitermaterial aufgebrachten Struktur, das eine nicht flüchtige Speicherzelle aufweist, in Form
eines MOS-Feldeffekt-Transistors mit einem Transistor-Gate (7a), und
einer MOS-Kapazität mit einem Kapazitäts-Gate (7b), und das
**gekennzeichnet ist durch**
eine Antenne (1, 2, 3), die mit dem Kapazitäts-Gate (7b) mittels einer Wirkverbindung verbunden ist, wobei
das Kapazitäts-Gate (7b) mit dem Transistor-Gate (7a) mittels einer weiteren Wirkverbindung derart verbunden ist, dass eine Aufladung der Antenne (1, 2, 3) über die Speicherzelle speicherbar und bei Bedarf abrufbar ist und wobei die Struktur einen CMOS-Technologie-artigen Aufbau aufweist.

2. Ladungsdetektor-Halbleiterbauelement nach Anspruch 1,
**gekennzeichnet durch**
einen ersten Bereich mit dem MOS-Feldeffekt-Transistor und einer eisten Wanne (p-Wanne) und einen zweiten Bereich mit der MOS-Kapazität und einer zweiten Wanne (n-Wanne) wobei die erste Wanne und die zweite Wanne mit unterschiedlichen Vorzeichen dotiert sind.

3. Ladungsdetektor-Halbleiterbauelement nach Anspruch 1 oder 2,
**dadurch gekennzeichnet,**
**dass** die Antenne (1, 2, 3), das Kapazitäts-Gate (7b) und das Transistor-Gate (7a), insbesondere zur Bildung eines Floating Gates (7), leitend verbunden sind, insbesondere galvanisch verbunden sind.

4. Ladungsdetektor-Halbleiterbauelement nach einem der Ansprüche 1 bis 3,
**dadurch gekennzeichnet,**
**dass** der MOS-Feldeffekt-Transistor ein NMOS-Feldeffekt-Transistor ist.

5. Ladungsdetektor-Halbleiterbauelement nach einem der Ansprüche 1 bis 4,
**dadurch gekennzeichnet,**
**dass** die MOS-Kapazität eine geschichtete Polysilizium/n/Wannen-Kapazität ist.

6. Ladungsdetektor-Halbleiterbauelement nach einem der Ansprüche 1 bis 5,
**dadurch gekennzeichnet,**
**dass** ein Steuer-Gate durch eine Wanne (n-Wanne) oder die Source/Drain-Anschlüsse der Kapazität gebildet ist.

7. Ladungsdetektor-Halbleiterbauelement nach einem der Ansprüche 1 bis 6,
**dadurch gekennzeichnet,**
**dass** das Transistor-Gate (7a) und das Kapazitäts-Gate (7b) als eine Polysiliziumplatte ausgerührt ist.

8. Ladungsdetektor-Halbleiterbauelement nach Anspruch 7,
**dadurch gekennzeichnet,**
**dass** die Fläche der Antenne (1, 2, 3) die Fläche der Polysiliziumplatte übersteigt.

9. Ladungsdetektor-Halbleiterbauelement nach einem der Ansprüche 1 bis 8,
**dadurch gekennzeichnet,**
**dass** die Antenne (1) als eine Polysilizium-Schicht ausgeführt ist.

10. Ladungsdetektor-Halbleiterbauelement nach einem der Ansprüche 1 bis 8,
    **dadurch gekennzeichnet,**
    **dass** die Antenne (1) aus Metall ausgeführt ist.

11. Ladungsdetektor-Halbleiterbauelement nach einem der Ansprüche 1 bis 10,
    **dadurch gekennzeichnet,**
    **dass** die Antenne (1, 2) als eine Kontakt-Antenne (2), insbesondere Via-Antenne (2), ausgeführt ist.

12. Ladungsdetektor-Halbleiterbauelement nach einem der Ansprüche 1 bis 11,
    **dadurch gekennzeichnet,**
    **dass** die Antenne (3) als eine MOS-Kapazität, insbesondere als eine NMOS-Kapazität, ausgeführt ist.

13. Ladungsdetektor-Halbleiterbauelement nach einem der Ansprüche 1 bis 12,
    **dadurch gekennzeichnet,**
    **dass** das Halbleiter-Material in einer ersten Ebene angeordnet ist, auf der die nicht-flüchtige Speicherzelle in einer zweiten Ebene aufgebracht ist, auf welcher wiederum die Verbindungen, das Transistor-Gate, das Kapazitäts-Gate sowie die Antenne in einer dritten Ebene aufgebracht ist.

14. Ladungsdetektor-Halbleiterbauelement nach einem der Ansprüche 1 bis 13,
    **dadurch gekennzeichnet,**
    **dass** das Transistor-Gate (7a) und das Kapazitäts-Gate (7b) gemeinsam in einer Polysilizium-Ebene verbunden sind.

15. System aus einem Ladungsdetektor-Halbleiterbauelement (9) und einem Referenz-Halbleiterbauelement, (19) in Form einer auf einem Halbleiter-Material aufgebrachten Struktur, wobei das Ladungsdetektor-Halbleiterbauelement (9) eine nicht-flüchtige Detektor-Speicherzelle aufweist, in Form
    eines ersten MOS-Feldeffekt-Transistors mit einem Detektor-Transistor-Gate (7a), und
    einer ersten MOS-Kapazität mit einem Detektor-Kapazitäts-Gate (7b), und eine Antenne (1, 2, 3) umfasst,
    die mit dem Detektor-Kapazitäts-Gate (7b) mittels einer ersten Wirkverbindung verbunden ist, wobei
    das Detektor-Kapazitäts-Gate (7b) mit dem Detektor-Transistor-Gate (7a) mittels einer weiteren ersten Wirkverbindung verbunden ist, und
    wobei das Referenz-Halbleiterbauelement (19)
    eine nicht-flüchtige Referenz-Speicherzelle aufweist, in Form
    eines zweiten MOS-Feldeffekt-Transistors mit einem Referenz-Transistor-Gate (27a), und
    einer zweiten MOS-Kapazität mit einem Referenz-Kapazitäts-Gate (27b),
    und eine Masseleitung (30, 31) umfasst,
    die mit dem Referenz-Kapazitäts-Gate (27b) mittels einer zweiten Wirkverbindung verbunden ist, wobei das Referenz-Kapazitäts-Gate (27b) mit dem Referenz-Transistor-Gate (27a) mittels einer weiteren zweiten Wirkverbindung verbunden ist, und wobei die Struktur einen CMOS-Technologie-artigen Aufbau aufweist.

16. Wafer, insbesondere Produktionswafer, mit einer Anzahl von Ladungsdetektor-Halbleiterbauelementen (9) nach Anspruch 1 und/oder Systemen (19) nach Anspruch 15.

17. Wafer nach Anspruch 16,
    **dadurch gekennzeichnet,**
    **dass** die Ladungsdetektor-Halbleiterbauelemente (9) und/oder Systeme (19) in einer Sägebahn des Wafers untergebracht sind.

18. Verwendung eines Wafers mit einer Anzahl von Ladungsdetektor-Halbleiterbauelementen (9) nach Anspruch 1 und/oder Systemen (19) nach Anspruch 15 zur qualitativen und quantitativen Messung einer Aufladung, insbesondere plasmainduzierten Aufladung, des Wafers während der Prozessierung des Wafers.

19. Verwendung eines Wafers nach Anspruch 18,
    **dadurch gekennzeichnet,**
    **dass** eine vorbestimmte örtliche Verteilung der Anzahl zur ortsaufgelösten und/oder prozessschrittselektiven Messung einer Aufladung, insbesondere plasmainduzierten Aufladung, des Wafers bei der Prozessierung des Wafers dient.

**20.** Verfahren zur qualitativen und quantitativen Messung einer Aufladung, insbesondere plasmainduzierten Aufladungen, eines Wafers bei der Prozessierung des Wafers, wobei

- der Wafer unter Verwendung einer CMOS-artigen Technologie hergestellt wird,
- der Wafer bei der Herstellung mit einem System aus einem Ladungsdetektor-Halbleiterbauelement (9) und einem Referenz-Halbleiterbauelement (19) versehen wird, wobei das Ladungsdetektor-Halbleiterbauelement (9) eine nicht-flüchtige Detektor-Speicherzelle aufweist, in Form
- eines ersten MOS-Feldeffekt-Transistors mit einem Detektor-Transistor-Gate (7a), und einer ersten MOS-Kapazität mit einem Detektor-Kapazitäts-Gate (7b), und eine Antenne (1, 2, 3) umfasst,
  die mit dem Detektor-Kapazitäts-Gate (7b) mittels einer ersten Wirkverbindung verbunden ist, wobei
  das Detektor-Kapazitäts-Gate (7b) mit dem Detektor-Transistor-Gate (7a) mittels einer weiteren ersten Wirkverbindung verbunden ist, und
  wobei das Referenz-Halbleiterbauelement (19)
  eine nicht-flüchtige Referenz-Speicherzelle aufweist, in Form
  eines zweiten MOS-Feldeffekt-Transistors mit einem Referenz-Transistor- Gate (27a), und
  einer zweiten MOS-Kapazität mit einem Referenz-Kapazitäts-Gate (27b),
  und eine Masseleitung (30, 31) umfasst,
  die mit dem Referenz-Kapazitäts-Gate (27b) mittels einer zweiten Wirkverbindung verbunden ist, wobei das Referenz-Kapazitäts-Gate (27b) mit dem Referenz-Transistor-Gate (27a) mittels einer weiteren zweiten Wirkverbindung verbunden ist
  und wobei die Struktur einen CMOS-Technologie-artigen Aufbau aufweist,
- bei der Prozessierung das Detektor-Kapazitäts-Gate (7b) über die Antenne (1, 2, 3) und das Referenz-Kapazitäts-Gate (27b) gegebenenfalls aufgeladen werden und das Referenz-Kapazitäts-Gate (27b) über die Masseleitung (30, 31) entladen wird,
- und die Aufladung des Detektor-Kapazitäts-Gates (7b) mit der Aufladung des Referenz-Kapazitäts-Gates (27b) mittels einer Messung verglichen wird.

**21.** Verfahren nach Anspruch 20,
**dadurch gekennzeichnet,**
**dass** der Wafer mit einer Anzahl von vorbestimmt örtlich verteilten Systemen hergestellt wird.

**22.** Verfahren nach Anspruch 20 oder 21,
**dadurch gekennzeichnet,**
**dass** zur Messung die Schwellspannung des Ladungsdetektor-Halbleiterbauelements (9) mit der Schwellspannung des Referenz-Halbleiterbauelements (19) verglichen wird.

**23.** Verfahren nach Anspruch 20 oder 21,
**dadurch gekennzeichnet,**
**dass** zur Messung Drain-Ströme bei gleich angelegten Steuergate-Potentialen jeweils des Ladungsdetektor-Bauelements (9) und des Referenz-Halbleiterbauelements (19) verglichen werden.

**24.** Verfahren nach Anspruch 23,
**dadurch gekennzeichnet,**
**dass** die Steuergate-Potentiale durch eine Wanne oder die Source/Drain-Anschlüsse der Kapazität des Detektor-Halbleiterbauelements (9) und des Referenz-Halbleiterbauelements (19) gebildet werden.

Fig. 1

Fig. 2

Fig. 3

EP 1 308 997 A2

$I_{DS}$

Antenne pos. geladen

Referenz

Antenne neg. geladen

$V_{Steuer-Gate}$

Fig. 4

19    30    9

$V_{ca}$

1,2,3

A    A

$V_{DS}$

Fig. 6

Fig. 5

EP 1 308 997 A2